# EUROPEAN PATENT SPECIFICATION

(11) **EP 1 630 127 B1**
(45) Date of publication and mention of the grant of the patent: **10.09.2008**
(21) Application number: 04425647.7
(22) Date of filing: 31.08.2004
(51) Int. Cl.: B81C 1/00, G03F 7/00, H01L 21/033

(54) **Method for realising a hosting structure of nanometric elements**
Verfahren zur Herstellung einer Wirtsstruktur für nanometergroße Elemente
Procédé de fabrication d'une structure pour héberger des élements d'une taille de quelques nanomètres

(43) Date of publication of application: 01.03.2006
(73) Proprietor: STMicroelectronics S.r.l., 20041 Agrate Brianza (Milano) (IT)
(72) Inventor: Mascolo, Danilo, 80056 Ercolano (IT); Cerofolini, Gianfranco, 20155 Milano (IT); Rizzotto, Gianguido, 23862 Civate (IT)
(74) Representative: Ferrari, Barbara

(56) References cited:
- WO-A-02/37571
- US-A1- 2002 043 690
- US-A1- 2003 059 983
- US-A1- 2004 146 863
- US-B1- 6 365 059

## Description

### Field of application

The present invention relates, in its more general aspect, to the field of the electronics with nanometric semiconductor electronic devices and to the field of the nano-manufacturing.

More in particular, the invention relates to a method for realising a hosting structure of nanometric elements realised on a substrate by means of subsequent deposition steps of layers of different materials alternated to respective anysotropic etching steps of these materials.

### Prior art

As it is well known, in the field of the microelectronics the need of realising circuit configurations of more and more reduced dimensions is particularly felt.

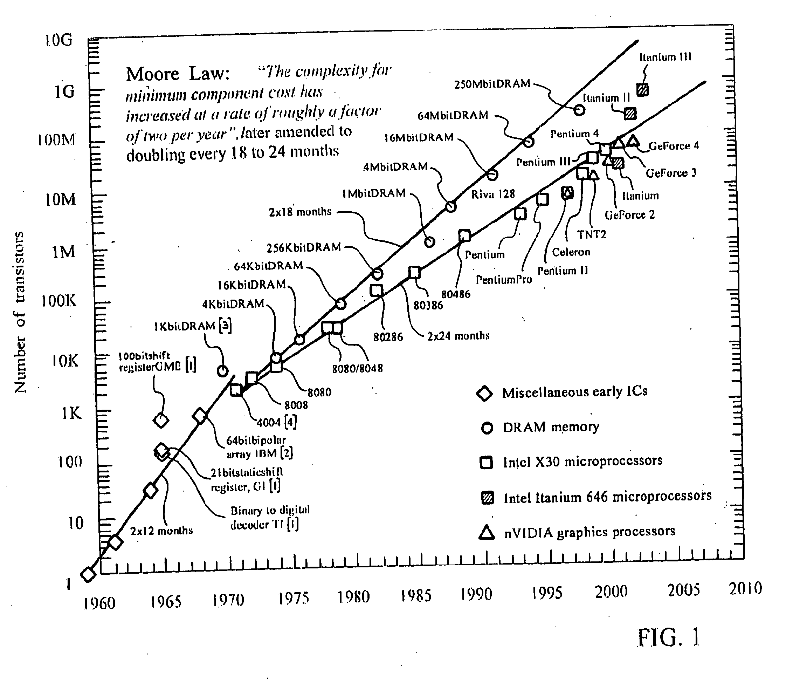

In the last thirty years, the progress of the electronic technology has followed a trend governed by that which is known as "Moore Law", an empirical law stating that the capacity of storing information in memory devices doubles each eighteen months approximately, whereas the calculation performance of the CPUs (Central Processing Units) improve of a factor each twenty-four months, as reported in the diagram of figure 1.

The Moore law is based on the capacity of reducing the geometries of the considered devices and it highlights how dimensions have passed from being equal to 2 µm for the eighties technologies, to being equal to 130 nm in 2001, to currently being equal to 90 nm.

However, the current technology is quickly reaching the physical limits of its possibilities; in particular, the used photolitography processes are subject to drastic dimensional limitations for values being lower than 100 nm.

Forward techniques have thus been developed such as x-ray non optic lithography or extreme ultra-violet lithography and as the electronic lithography which allow to realise circuit configurations with dimensions in the order of some tens of nanometres.

These techniques, however, require complex instruments characterised by excessively long times of lithographic etching and they thus result too expensive for being applied to a mass industrial manufacturing.

As an alternative, sub-lithographic patterning techniques have been developed based on controlled (conformable) deposition and of selective removal of a functional material on a suitable layer for realising nanometric elements.

These techniques have allowed the adjustment of methods for realising semiconductor substrates suitable for obtaining different typologies of components, as for example indicated in the US patents no. 6,570,220 and no. 6 063 688 both to Doyle et el..

In particular, in these patents a deep submicrometric structure is described for components and, respectively, a relative method for realising it. This method provides the realisation, on a silicon substrate by means of lithography, of first spacers in a first material whereon, by means of controlled deposition, a layer of a second material is realised. Moreover the thickness of the layer of the second material is approximately half the width of the first spacers.

The selective removal of the second material, carried by means of anisotropic etching, thus defines second spacers each being adjacent to respective side portions of the first spacers, and each having width equal to the thickness of the layer of this second material.

With a successive selective chemical etching the first spacers are removed, leaving on the surface of the semiconductor substrate only the second spacers. The deposition of a layer of a third material, controlled in the thickness, followed by a selective removal with anisotropic etching, defines third spacers.

These third spacers, each adjacent to respective side portions of the second spacers, have a width equal to the thickness of the layer of the third material. With a selective chemical etching the second spacers are removed leaving on the surface of the semiconductor surface the sole third spacers.

The operations of controlled depositions, of anisotropic etching and of selective etching are repeated more than once, for realising spacers of reduced width up to 100 Å separated from one another by a distance of around 200 Å. By depositing, finally, some dielectric material in the region defined between two consecutive spacers, a conductive region is realised which can be used for realising a CMOS transistor.

The above method needs, however, a preliminary and accurate programming since each realisation step of an n order (with n >= 2) of spacers is followed by a removal step of the spacers of order (n-1), and it is thus necessary to provide a suitable distance and a suitable thickness of the first spacers for realising last spacers of desired dimensions.

In the US patent no. 6 187 694 to Cheng et al. a method is also described for realising a structure of an integrated circuit, for example a gate electrode of a MOS transistor, by using two edge definition layers and a spacer realised above a substrate. The gate electrode is realised, on the substrate portion below the spacer, by means of a succession of chemical etchings, each suitable for selectively removing portions of edge definition layers and substrate portions.

These selective etchings are preceded by depositions of materials by means of masking.

Finally, US patent no. 6,664,173 to Doyle et al., a technique is described for patterning a hardmask gate, for all the typologies of components, by using a gate spacer for approaching nanometric masks. This technique provides starting from a unit comprising a substrate whereon first gate and respectively hardmask layers and subsequent second gate and hardmask layers are deposited.

On the second hardmask layer, by means of deposition and thus etching steps, a nanometric spacer is defined used as mask for realising a gate electrode for a first transistor.

From the first hardmask layer of the same unit a structure is realised for a second transistor further to other deposition and etching steps.

Subsequent steps are however required for realising a MOS device.

Although satisfying the aim, this method is limited in that it allows to realise, although of nanometric dimensions, a single gate electrode for a transistor.

In substance, all the known methods clash with the need of realising nanometric structures and provided with suitable conduction and control terminals for using them as semiconductor electronic devices.

US 2004/0146863 discloses an apparatus and a respective method of manufacturing in which the apparatus comprises a firs electrode, a second electrode, an insulator between the electrodes and a biological macromolecule connecting the first electrode to the second electrode.

WO 02/37571 discloses a structure and a respective method of manufacturing, in which the structure is formed from at least two layers of material separated by at least another layer. The layers are formed and/or processed such that a gap is formed between the at least two layer, and at least one small-scale element is arranged within the gap.

The technical problem underlying the present invention is that of providing a method for realising a hosting structure of nanometric elements overcoming the dimensional limits of the semiconductor electronic devices realised according to the methods provided by the prior art.

### Summary of the invention

The solution idea underlying the present invention is that of providing a structure suitable for realising conduction terminals for at least one nanometric component realised by means of a molecular component, i.e. by means of a functionalised molecule capable of performing specific actions.

On the basis of this solution idea the technical problem is solved by a method for realising a nanometric structure capable of hosting the above molecular components and capable of realising the conduction terminals for these components as defined by the characterising part of claim 1.

In substance, according to the invention a method is devised for realising a structure capable of hosting the above molecular components realising semiconductor electronic devices of the hybrid type.

The characteristics and advantages of the method according to the invention will be apparent from the following description of an embodiment thereof given by way of indicative and non limiting example making reference to the annexed drawings.

### Brief description of the drawings

Figure 1 is a diagram reporting the Moore Law;
Figures from 2 to 11 show in sequence the steps of the method according to the invention for realising a nanometric structure;
Figures 12 and 13 show a further embodiment of a nanometric structure realised with the method according to the invention;
Figure 14 shows a further embodiment of a nanometric structure according to the invention in an intermediate step of the method.

### Detailed description

The hereafter described steps are not a complete flow of a method for realising a hosting structure for a plurality of nanometric electronic components and hereafter only the steps necessary to a medium technician of the field for the comprehension of the invention are described. The present invention can be put in practice by using the usual techniques employed in the manufacturing of the semiconductor electronic devices.

Moreover, the figures showing schematic views of portions of an integrated circuit during the manufacturing are not drawn to scale but they are instead drawn so as to underline the important characteristics of the invention.

The present invention starts from the idea of realising an electronic device comprising a plurality of molecular components as nanometric elements as well as a single hosting structure capable of hosting this plurality of molecular components and of realising the conduction and control terminals.

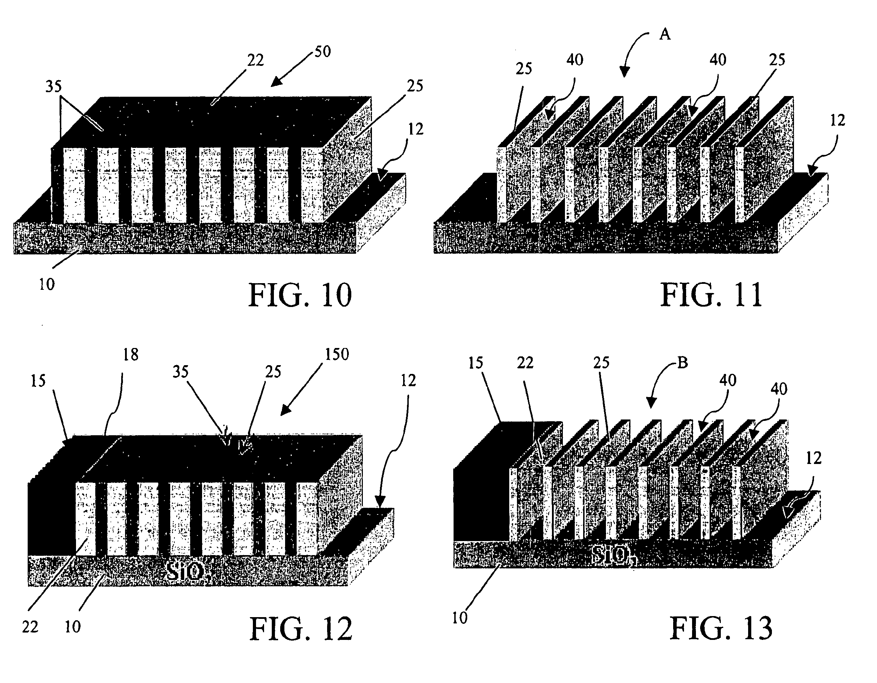

Such a hosting structure A is shown in figure 11.

In particular, the hosting structure A, realised on a substrate 10, comprises a plurality of bar-like elements commonly indicated as spacers 25, made of conductive material, parallel and equidistant from each other, perpendicular to an upper surface 12 of the substrate 10.

The thus defined hosting structure A, realises a plurality of hosting seats 40 for nanometric elements, in particular molecular components, not shown in the figures, the above spacers 25 defining respective conduction terminals for these molecular components.

The hosting structure A is realised by means of an etching step of a multilayer body 50 as that shown in figure 10.

In particular, the multilayer body 50 is realised above the substrate 10, made of a first material for example silicon dioxide, and it comprises n spacers 25, 35 alternated and made of at least two different materials, respectively conductive and insulating. This multilayer body 50 is realised in accordance with the method according to the invention as shown in the figures from 2 to 10.

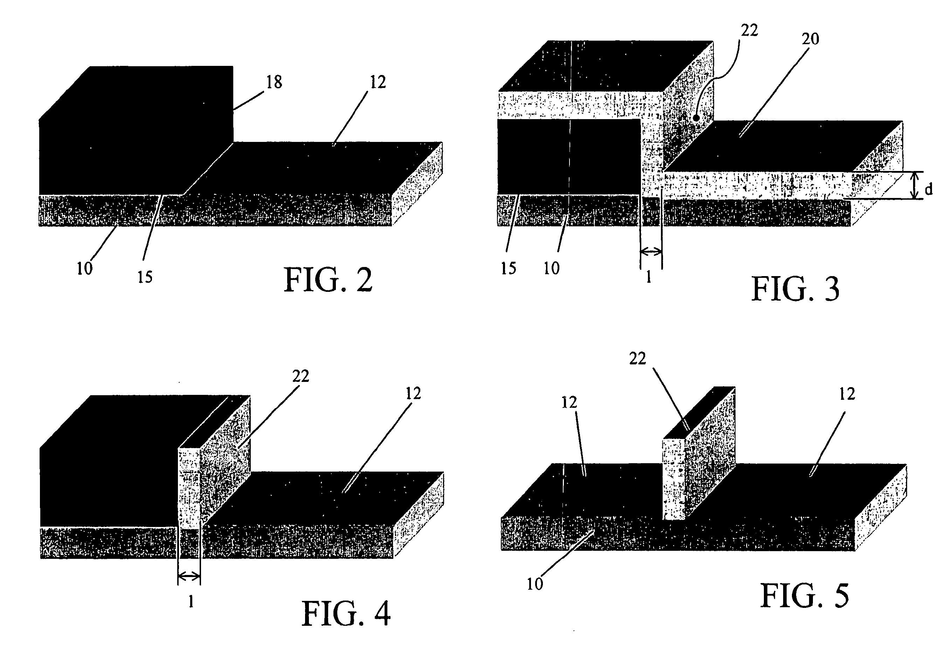

In particular, in the method according to the invention, a block-seed 15 realised by means of a conventional photolitographic deposition step, is first deposited, as shown in figure 2, on a peripheral portion of the surface 12.

This deposition step is suitably followed by a conventional chemical etching step, by using for example a solution of CHF₃/O₂ which allows to square the block-seed 15 realising thereon at least one side wall 18 arranged perpendicularly to the surface 12.

The method thus provides a deposition step on the surface 12 and above the block-seed 15, of a first layer 20 of predetermined thickness of a second material. In particular, with reference to the example of figure 3, the first layer 20 is defined by a thin film of conductive material, such as polysilicon, deposited with a predetermined and uniform thickness indicated with "d".

Preferably, the thickness "d" has nanometric dimensions and the scalability thereof up to 5 nm has been demonstrated. In general, nanometric dimensions refer to layers with thickness lower than 30 nm and most preferably below 10 nm.

This first layer 20, deposited according to conventional techniques, results conformably adapted to the underlying topography, i.e. in particularly it has a portion 22 adjacent to the side wall 18 of the block-seed 15, which has a width "1" equal to the above thickness "d" of the first layer 20.

Subsequently, according to conventional techniques, an anisotropic etching step follows of the first layer 20, which is thus removed except for the above portion 22 adjacent to the side wall 18, as highlighted in figure 4.

In particular, the etching of the first layer 20 is performed anisotropically along the direction perpendicular to the surface 12 of the substrate 10 by means of sputtering.

The residual portion 22 of the first layer 20 further indicated also as spacer-seed is arranged perpendicularly to the surface 12 of the substrate 10.

With particular reference to figure 5, the spacer-seed 22 is shown after a removal step of the block-seed 15, however, in the method according to the invention, this removal step can be provided after the realisation of the whole multilayer body 50.

In particular, the removal step of the block-seed 15 occurs by means of selective chemical etching (H₃PO₄ for example for nitride).

Obviously, the spacer-seed 22 in integral with the multilayer body 50, as better highlighted in figure 10.

According to the invention, the method provides n repetitions, with n >= 2, of a step comprising a deposition, on at least one portion of the substrate 10, of a layer of predetermined thickness of a predetermined material followed by an anisotropic etching of the same layer with the realisation of at least a relative spacer analogue to the spacer-seed 22, perpendicular to the upper surface 12 of the substrate 10.

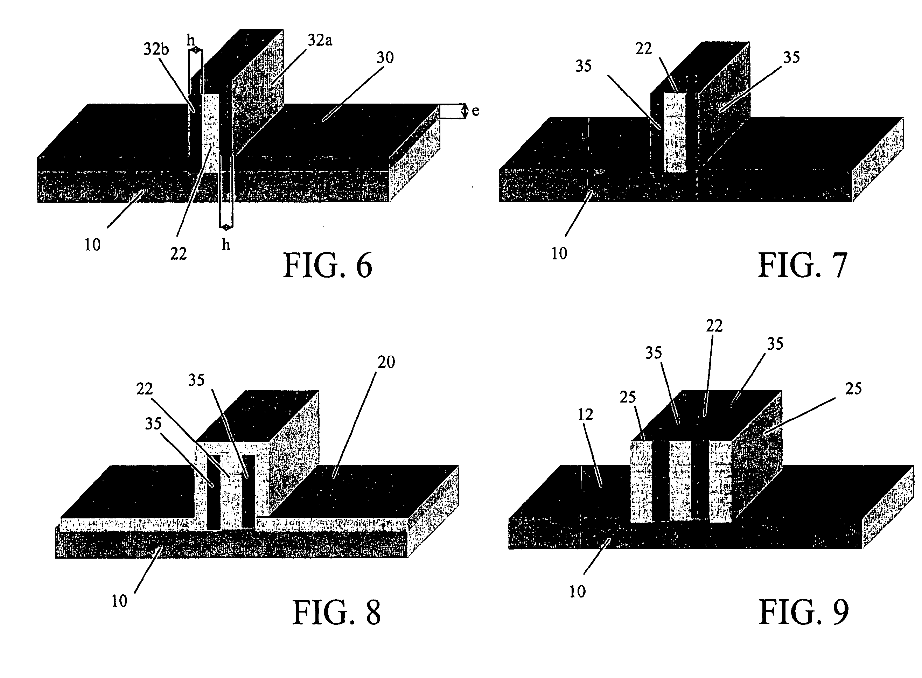

More in particular, as better highlighted in figure 6, the method thus provides a deposition of a second layer 30 of a third material, for example silicon nitride or other insulating material such as an oxide, deposited with a predetermined and uniform thickness indicated with "e".

Preferably, the thickness "e" is nanometric and it is determined by the dimension of the molecule to be hosted, controlled up to 1 nm.

Obviously, in the case where the third material is an oxide, deposition is intended as any step suitable for realising the second layer 30, thus realised both by means of effective deposition of the oxide, for example by means of "CVD-oxide" (control vapour deposition oxide), and by means of growth of the oxide itself from the underlying layer, for example by means of "Thermal Oxidation" technique.

This second layer 30 is deposited on the surface 12 and on the spacer-seed 22, so that it results to be adapted to the underlying topography similarly to what has been described above for the deposition of the first layer 30.

In particular, as highlighted always in figure 6, the second layer 30 has a first portion 32a and a second portion 32b adjacent to opposed side walls of the spacer-seed 22 and having a width "h" equal to the above thickness "e" of the second layer 30.

Through an anisotropic etching the third material is removed except for the first and the second portion 32a, 32b of the second layer 30, which define respective spacers 35, as better highlighted in figure 7.

The method thus provides another step comprising a further deposition of a layer of the second material, similar to the first layer 20, deposited with a predetermined and uniform thickness on the surface 12, on the spacer-seed 22 and on the spacer 35, as highlighted in figure 8. Said step thus comprises an anisotropic etching of said layer to define spacer 25, as better highlighted in figure 9.

Substantially, according to the invention, first and second layers 20, 30, are alternatively deposited by repeating n times the above described step comprising a deposition of a layer followed by an anisotropic etching of the same layer.

As result of the above n steps, the multilayer body 50 is realised comprising a plurality of spacers 25 alternated to a plurality of spacers 35 and the spacer-seed 22, as shown in figure 10.

A removal step of the plurality of spacers 35, through a conventional plasma etching selective with respect to the third material which realises the second layers 30, determines the formation of the nanometric hosting structure A comprising a plurality of spacers 25 realised from the second material suitable for defining a plurality of hosting seats 40 for molecular components, each hosting seat 40 being defined by the gap between a spacer 25 and a subsequent one, as highlighted in the example of figure 11.

Moreover, as always highlighted in the example of figure 11, the widths of such spacers 25 are all equal to each other, being however possible to realise spacers 25 having non-uniform dimensions with one another, by depositing first layers 20 of different thickness.

Advantageously, also the widths of the spacers 35 can be provided with predetermined values, also different from one another, according to the final use provided for the hosting structure A and to the dimensions of the molecular components intended for being hosted therein.

In the shown example, the multilayer body 50 develops in opposite directions with respect to the spacer-seed 22, the block-seed having been removed. It would be also possible to realise a multilayer body 50 which develops from the spacer-seed 22 in a single direction with respect to the block-seed 15 if the removal thereof would have not been carried out.

With reference to figure 12, a multilayer body 150 is shown being realised by means of a further embodiment of the method according to the invention. In this embodiment the realisation details of the preceding example will be indicated with the same reference numbers.

As above described in connection with figures 1-11, by means of a photolitographic deposition step on a substrate 10 made with a first material, for example silicon oxide, a block-seed 15 is realised.

This block-seed 15 is for example realised with a specific material, such as silicon nitride. It is also possible to realise such block-seed 15 by depositing a plurality of overlapped layers also of different materials.

By means of a chemical etching step on the block-seed 15 a side wall 18 is defined perpendicular to a surface 12 of the substrate 10.

The method thus provides a step comprising a deposition on the surface 12 and on the block-seed 15 of a first layer of a second material followed by an anisotropic etching of this first layer so as to realise a spacer-seed 22 adjacent to the side wall 18.

In particular, in this embodiment of the method according to the invention, the block-seed 15 is not removed until the end of the realisation of the whole multilayer body 150.

A step comprising a deposition on the surface 12, on the block-seed 15 and on the spacer-seed 22 of a second layer of a third material followed by an anisotropic etching of such second layer defines a single spacer 35 adjacent to the spacer-seed 22.

The above first and second layer are respectively of conductive material and of insulating material for example of polysilicon and silicon oxide.

According to the invention, the method provides the n repetition, with n >=2, of a step comprising a deposition, on at least one portion of the substrate 10, of a layer of predetermined thickness of a predetermined material followed by an anisotropic etching of the same layer with realisation of at least a relative spacer 25, 35.

In this embodiment, the predetermined material is differently chosen for each pair of consecutive depositions, the n steps defining at least one multilayer body 150 comprising a plurality of spacers 25, 35 realised with at least two different materials and said at least one spacer-seed 22.

A removal step of the plurality of elements of second layers 35 through a selective plasma etching towards the silicon oxide determines the formation of a nanometric hosting structure B, as shown in the example of figure 13.

The hosting structure B comprises a plurality of spacers 25 realised with the second material suitable for defining a plurality of hosting seats 40 for molecular components, each hosting seat 40 being defined by the gap between a spacer 25 and a subsequent one.

In substance, the spacers 25 of the hosting structure A or B, define conduction terminals for the nanometric molecular components hosted in the structure itself and not highlighted in the figures.

In the shown example, the multilayer body 150 develops from the spacer-seed 22 in a single direction with respect to the block-seed 15. It would also be possible to realise a multilayer body 150 developing in opposite directions with respect to the spacer-seed 22, by attending to the removal of the block-seed.

Obviously, a second multilayer body can be realised on the same substrate 10 adjacent to a side wall opposite to the side wall 18 of the same seed-block 15.

This second multilayer body realised by means of the same method step above described is not shown in the annexed figures.

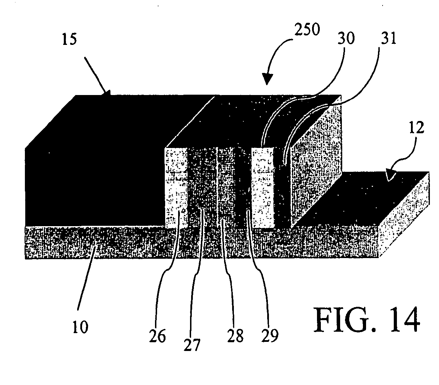

Advantageously, the above steps comprising the deposition of first and second layers can be provided by using different materials deposited with predetermined thickness, also different from one another, realising a multilayer body 250 comprising a plurality of different spacers as indicated in the example of figure 14 where the spacers 26-31 can be made with different materials and/or have different thickness.

One or more removals through one or more plasma etchings, selective towards the respective materials of the spacers, determines the formation of a nanometric hosting structure with conduction terminals defined by spacers different from one another in thickness and material.

It is thus possible to realise a nanometric electronic device by providing a nanometric hosting structure realised as previously described and to host therein a plurality of nanometric elements, in particular molecular components having respective conduction terminals realised by the spacers of the hosting structure.

In particular, it is possible to predispose the hosting structure for hosting molecular components as described in the European patent application no. 1 278 234 filed on 23/11/2001 to the Applicant itself. By using the method described in such application, the molecular components in the hosting seats of the structure automatically bond to the conductive spacers which realise the conduction terminals.

Advantageously, the realisation of the hosting structure is completed prior to the hosting therein of the molecular components and to the subsequent realisation of the desired hybrid semiconductor device. In this way, the molecular components do not undergo any stress linked to process steps for realising the hosting structure.

The main advantage of the method according to the present invention is represented by the fact of realising a nanometric hosting structure suitable for hosting and realising nanometric control terminals of nanometric elements, in particular molecular components.

In particular, the method according to the invention allows to realise a plurality of nanometric conduction terminals suitable for addressing the above molecular components and able to suitably orient the functionalised molecules which realise them and control them to perform specific actions.

A further advantage of the present method is that of realising a hosting structure of the above described type, wherein the plurality of hosting seats and the conduction terminals can be realised with different dimensions, in particular scaling down.

Such structure allows both to host molecular components of different nature and dimensions and to test and individually question the single terminals.

A further advantage of the method according to the invention stays in its easiness and speed of realisation, since steps are provided which can be easily integrated in the productive process currently in use for obtaining semiconductor devices.

In substance, thanks to the present invention, it is possible to realise a nanometric structure, wherein suitably functionalised molecules are hosted in the seats defined between two consecutive spacers suitable for realising contact and control terminals for such molecules, which are suitably addressed in correspondence with such terminals thus realising a semiconductor device of the hybrid type comprising a plurality of nanometric elements, in particular molecular components.

## Claims

1. Method for realising a hosting structure of nanometric elements which comprises the steps of:
- depositing on an upper surface (12) of an insulating substrate (10), of a first material, a block-seed (15) having at least one side wall (18) perpendicular to said upper surface (12);
- depositing on at least one portion of said surface (12) and of said block-seed (15) a first layer (20) of predetermined thickness of a second material, said first layer (20) having a portion that covers at least a portion of said at least one side wall (18);
- anisotropically etching said first layer (20) which is removed with the exception of said portion that covers at least said portion of said at least one side wall (18), obtaining at least one spacer-seed (22) adjacent to said at least one portion of said side wall (18) of said block-seed (15);
**characterised in that** the method further comprises the following steps:
- repeating n times, with n >= 2, a step comprising a deposition on at least one portion of said substrate (10) of a layer (20, 30) of a predetermined thickness of a predetermined material so that said layer (20, 30) results to be adapted to the underlying topography, followed by an anisotropic etching of said layer (20, 30) which is removed with the exception of a portion that covers at least a portion of at least one side wall of the underlying topography, with realisation of at least one relative spacer (25, 35), said predetermined material being different for each pair of consecutive depositions, said n steps defining at least one multilayer body (50, 150, 250) comprising n spacers (25; 35) made of at least two different materials and said at least one spacer-seed (22);
- selectively etching said multilayer body (50, 150, 250) removing a fraction of said spacers (25, 35) for realising at least one plurality of nanometric hosting seats (40);
said structure (A, B) thus realised being suitable for hosting in said at least one plurality of hosting seats (40) a plurality of nanometric elements, a remaining fraction of said spacers (25) realising contract terminals for said elements.

2. Method according to claim 1, **characterised in that** it further comprises, after the realisation of said spacer-seed (22) the step of:
anisotropically etching said block seed (15) with its consequent entire removal.

3. Method according to claim 1, **characterised in that** it comprises an anisotropic etching step of said block seed (15) in which said block seed (15) is entirely revoved, said etching step being a step provided after the realisation of said multilayer body (50, 150, 250).

4. Method according to any of the preceding claims, **characterised in that** in each pair of said consecutive depositions, said at least two different materials are a conductive material and an insulating material with realisation, further to said selective and anisotropic etchings, of said spacers (25, 35) respectively conductive and insulating.

5. Method according to claim 4, **characterised in that** said depositions of conductive material deposit layers of equal thickness to each other, with realisation of conductive spacers (25) having equal width to each other.

6. Method according to claim 4, **characterised in that** said depositions of insulating material deposit layers of equal thickness to each other, with realisation of said insulating spacers (35) having equal width to each other.

7. Method according to claim 4, **characterised in that** said depositions of conductive material deposit layers of different thickness to each other, with realisation of said conductive spacers (25) having different width to each other.

8. Method according to claim 4, **characterised in that** said depositions of insulating material deposit layers of different thickness to each other, with realisation of said insulating spacers (35) having different width to each other.

9. Method according to any of the preceding claims, **characterised in that** said depositions deposit said layers with said thickness preferably under 30 nm and most preferably between 1 nm and 5 nm.

10. Method according to any of the preceding claims, **characterised in that** said nanometric elements comprise molecular components realised by functionalised molecules.

## Patentansprüche

1. Verfahren zur Herstellung einer Aufnahmestruktur für nanometergroße Elemente, folgende Schritte aufweisend:
- Abscheiden, auf einer oberen Oberfläche (12) eines isolierenden Substrats (10) aus einem ersten Material, eines Blockkeims (15) mit mindestens einer Seitenwand (18), die zu der oberen Oberfläche (12) senkrecht ist;
- Abscheiden, auf mindestens einem Bereich der Oberfläche (12) und des Blockkeims (15), einer ersten Schicht (20) vorbestimmter Dicke aus einem zweiten Material, wobei die erste Schicht (20) einen Bereich hat, der mindestens einen Bereich der mindestens einen Seitenwand (18) bedeckt;
- anisotrop Ätzen der ersten Schicht (20), die mit Ausnahme des Bereichs, der mindestens den Bereich der mindestens einen Seitenwand (18) bedeckt, entfernt wird, wobei mindestens ein Trennelementkeim (22) erhalten wird, der dem mindestens einen Bereich der Seitenwand (18) des Blockkeims (15) benachbart ist;
**dadurch gekennzeichnet, dass** das Verfahren außerdem die folgenden Schritte aufweist:
- n-mal Wiederholen, mit n>=2, eines Schritts, der eine Abscheidung einer Schicht (20, 30) einer vorbestimmten Dicke aus einem vorbestimmten Material auf mindestens einem Bereich des Substrats (10) aufweist, so dass die Schicht (20, 30), die an die darunter liegende Topographie anzupassen ist, resultiert, gefolgt von einem anisotropen Ätzen der Schicht (20, 30), die mit Ausnahme eines Bereichs, der mindestens einen Bereich der mindestens einen Seitenwand der darunter liegenden Topographie bedeckt, entfernt wird, unter Herstellung mindestens eines jeweiligen Trennelements (25, 35), wobei das vorbestimmte Material für jedes Paar von aufeinander folgenden Abscheidungen unterschiedlich ist, wobei die n Schritte mindestens einen Mehrschichtkörper (50, 150, 250), der n Trennelemente (25, 35), die aus mindestens zwei unterschiedlichen Materialien hergestellt sind, und den mindestens einen Trennelementkeim (22) aufweist, definieren;
- selektiv Ätzen des Mehrschichtkörpers (50, 150, 250) unter Entfernen eines Bruchteils der Trennelemente (25, 35), um mindestens eine Mehrzahl von nanometergroßen Aufnahmesitzen (40) herzustellen;
wobei die auf diese Weise hergestellte Struktur (A, B) dazu geeignet ist, in der mindestens einen Mehrzahl von Aufnahmesitzen (40) eine Mehrzahl von nanometergroßen Elementen aufzunehmen, wobei ein verbleibender Bruchteil der Trennelemente (25) Kontaktanschlüsse für die Elemente bildet.

2. Verfahren nach Anspruch 1, **dadurch gekennzeichnet, dass** es außerdem, nach der Herstellung des Trennelementkeims (22), folgenden Schritt aufweist:
anisotrop Ätzen des Blockkeims (15) unter seiner darauf folgenden völligen Entfernung.

3. Verfahren nach Anspruch 1, **dadurch gekennzeichnet, dass** es einen Schritt des anisotrop Ätzens des Blockkeims (15) aufweist, bei dem der Blockkeim (15) völlig entfernt wird, wobei der Ätzschritt ein Schritt ist, der nach der Herstellung des Mehrschichtkörpers (50, 150, 250) vorgesehen wird.

4. Verfahren nach irgendeinem der vorangehenden Ansprüche, **dadurch gekennzeichnet, dass** bei jedem Paar der aufeinander folgenden Abscheidungen die mindestens zwei unterschiedlichen Materialien ein leitfähiges Material und ein isolierendes Material sind, wobei die Trennelemente (25, 35), zusätzlich zu den selektiven und anisotropen Ätzungen, leitfähig bzw. isolierend hergestellt werden.

5. Verfahren nach Anspruch 4, **dadurch gekennzeichnet, dass** die Abscheidungen von leitfähigem Material Schichten von zueinander gleicher Dicke abscheiden, wobei leitfähige Trennelemente (25) mit zueinander gleicher Breite hergestellt werden.

6. Verfahren nach Anspruch 4, **dadurch gekennzeichnet, dass** die Abscheidungen von isolierendem Material Schichten von zueinander gleicher Dicke abscheiden, wobei die isolierenden Trennelemente (35) mit zueinander gleicher Breite hergestellt werden.

7. Verfahren nach Anspruch 4, **dadurch gekennzeichnet, dass** die Abscheidungen von leitfähigem Material Schichten von voneinander verschiedener Dicke abscheiden, wobei die leitfähigen Trennelemente (25) mit voneinander verschiedener Breite hergestellt werden.

8. Verfahren nach Anspruch 4, **dadurch gekennzeichnet, dass** die Abscheidungen von isolierendem Material Schichten von voneinander verschiedener Dicke abscheiden, wobei die isolierenden Trennelemente (35) mit voneinander verschiedener Breite hergestellt werden.

9. Verfahren nach irgendeinem der vorangehenden Ansprüche, **dadurch gekennzeichnet, dass** die Abscheidungen Schichten, deren Dicke bevorzugt unter 30 nm und am meisten bevorzugt zwischen 1 nm und 5 nm liegt, abscheiden.

10. Verfahren nach irgendeinem der vorangehenden Ansprüche, **dadurch gekennzeichnet, dass** die nanometergroßen Elemente molekulare Komponenten, die von funktionalisierten Molekulen gebildet werden, aufweisen.

## Revendications

1. Procédé de réalisation d'une structure d'accueil d'éléments nanométriques comprenant les étapes suivantes :
déposer sur une surface supérieure (12) d'un substrat isolant (10) en un premier matériau un bloc-germe (15) ayant au moins une paroi latérale (18) perpendiculaire à la surface supérieure (12) ;
déposer sur au moins une partie de la surface (12) et du bloc-germe (15) une première couche (20) d'épaisseur prédéterminée en un second matériau, la première couche (20) ayant une partie qui couvre au moins une partie de ladite au moins une paroi latérale (18) ;
graver de façon anisotrope la première couche (20) qui est supprimée à l'exception de la partie qui recouvre au moins ladite partie de ladite au moins une paroi latérale (18), fournissant au moins un espaceur-germe (22) adjacent à au moins une partie de la paroi latérale (18) du bloc-germe (15) ;
**caractérisé en ce que** le procédé comprend en outre les étapes suivantes :
répéter n fois, avec n ≥ 2, une étape comprenant le dépôt sur au moins une partie du substrat (10) d'une couche (20, 30) d'une épaisseur prédéterminée d'un matériau prédéterminé de sorte que la couche (20, 30) est en conséquence adaptée à la topographie sous-jacente, suivi d'une gravure anisotrope de la couche (20, 30) qui est supprimée à l'exception d'une partie qui recouvre au moins une partie d'au moins une paroi latérale de la topographie sous-jacente, avec réalisation d'au moins un espaceur relatif (25, 35), le matériau prédéterminé étant différent pour chaque paire de dépôts successifs, les n étapes définissant au moins un corps multicouche (50, 150, 250) comprenant n espaceurs (25, 35) en au moins deux matériaux différents et au moins un espaceur-germe (22) ;
graver sélectivement le corps multicouche (50, 150, 250) en enlevant une fraction des espaceurs (25, 35) pour réaliser au moins une pluralité de sièges d'accueil nanométriques (40) ;
la structure (A, B) ainsi réalisée étant adaptée à recevoir dans ladite au moins une pluralité de sièges d'accueil (40) une pluralité d'éléments nanométriques, une fraction restante des espaceurs (25) réalisant des bornes de contact pour les éléments.

2. Procédé selon la revendication 1, **caractérisé en ce qu'**il comprend en outre, après la réalisation des espaceurs-germes (22), l'étape consistant à :
graver de façon anisotrope le bloc-germe (15) et le supprimer en conséquence complètement.

3. Procédé selon la revendication 1, **caractérisé en ce qu'**il comprend une étape de gravure anisotrope du bloc-germe (15) dans laquelle le bloc-germe (15) est complètement supprimé, l'étape de gravure étant une étape prévue après la réalisation du corps multicouche (50, 150, 250).

4. Procédé selon l'une quelconque des revendications précédentes, **caractérisé en ce que**, dans chaque paire de dépôts successifs, lesdits au moins deux matériaux différents sont un matériau conducteur et un matériau isolant avec réalisation, après les gravures sélectives et anisotropes, desdits espaceurs (25, 35) respectivement conducteurs et isolants.

5. Procédé selon la revendication 4, **caractérisé en ce que** les dépôts de matériau conducteur déposent des couches de même épaisseur, d'où il résulte des espaceurs conducteurs (25) ayant une même largeur.

6. Procédé selon la revendication 4, **caractérisé en ce que** les dépôts de matériau isolant déposent des couches de même épaisseur, d'où il résulte des espaceurs isolants (35) ayant une même largeur.

7. Procédé selon la revendication 4, **caractérisé en ce que** les dépôts de matériau conducteur déposent des couches d'épaisseurs différentes, d'où il résulte des espaceurs conducteurs (25) d'épaisseurs différentes.

8. Procédé selon la revendication 4, **caractérisé en ce que** les dépôts de matériau isolant déposent des couches d'épaisseurs différentes, d'où il résulte des espaceurs isolants (35) d'épaisseurs différentes.

9. Procédé selon l'une quelconque des revendications précédentes, **caractérisé en ce que** les dépôts déposent lesdites couches avec des épaisseurs de préférence inférieures à 30 nm et encore de préférence comprises entre 1 nm et 5 nm.

10. Procédé selon l'une quelconque des revendications précédentes, **caractérisé en ce que** les éléments nanométriques comprennent des composants moléculaires réalisés par des molécules fonctionnalisées.
